# EUROPEAN PATENT APPLICATION

(11) **EP 4 471 851 A1**
(43) Date of publication of application: **04.12.2024**
(21) Application number: 24175169.2
(22) Date of filing: 10.05.2024
(51) Int. Cl.: H01L 23/482, H01L 23/66, H01L 29/20

(54) **HEMT POWER DEVICE WITH REDUCED GATE OSCILLATION AND MANUFACTURING PROCESS THEREOF**

(30) Priority: 31.05.2023 IT 202300011085
(71) Applicant: STMicroelectronics International N.V., 1228 Plan-les-Ouates, Geneva (CH)
(72) Inventor: PIZZARDI, Antonio Filippo Massimo, 95045 Misterbianco (CT) (IT); SMERZI, Santo Alessandro, 95127 Catania (IT); IUCULANO, Ferdinando, 95030 Gravina di Catania (CT) (IT)
(74) Representative: Studio Torta S.p.A.

(57) **Abstract**

A heterojunction power device (1) includes: a substrate (21) containing semiconductor material; a first active area (20a) and a second active area (20b), arranged on the substrate (21) symmetrically opposite with respect to an axis of symmetry (H) and accommodating respective heterostructures (25, 27, 29); a separation region (23), extending along the axis of symmetry (H) between the first active area (20a) and the second active area (20b). The power device (1) further comprises: a gate conductive bus (35) configured to distribute a first electric potential (V_{G}) of the power device (1) in parallel to the first and the second active areas (20a, 20b); a source conductive bus (55) configured to distribute a second electric potential (V_{S}) of the power device (1), different from the first electric potential (V_{G}), in parallel to the first and the second active areas (20a, 20b). The gate conductive bus (35) and the source conductive bus (55) extend along the axis of symmetry (H) above the separation region (23) and the source conductive bus (55) overlies the gate conductive bus (35).

## Description

### Technical field

The present invention relates to a "High Electron Mobility Transistor" (HEMT) power device with reduced gate oscillation and manufacturing process thereof.

### Background

HEMT devices, also often referred to as "Heterostructure Field Effect Transistors" (HFET), have characteristics that make them increasingly suitable and widespread in high-power and fast-switching applications; these characteristics include their ability to operate at high voltages and their high breakdown voltage, with values up to several hundreds of Volts, as well as the high density and mobility of the charge carriers.

In a HEMT device, a semiconductive heterostructure (generally based on AlGaN/GaN layers and therefore the device is also referred to as "GaN power device") allows a so-called two-dimensional electron gas (2DEG) to be generated spontaneously in the device, effectively forming a conductive channel for electric charges. The spontaneous channel may be modulated, in use, by applying suitable voltages to a gate region (commonly referred to as "gate") of the device.

GaN power devices used in fast-switching applications - such as, for example, electric traction and energy transformation, with typical "half-bridge" circuit configurations - are subject to high gradients of the voltage between the drain and source terminals (commonly referred to as drain terminal and source terminal) and of the current flowing between these terminals. The rapid variations of the drain-source voltage and of the current thereof over time may be combined, in this type of devices, with relatively low threshold voltage levels, i.e. on-voltage levels of the device, at the gate terminal (in the order of a few Volts).

For a safe operation of the power device it is necessary to protect the gate terminal from voltage peaks that may exceed the threshold voltage; these peaks may be induced, for example, by the Miller effect or by oscillations due to resonance phenomena involving the inductance of the conductive paths of the gate signal and the capacitance of the device substrate. The oscillations on the gate terminal, which may be of sustained type (i.e. lasting over time) or of "ringing" type (i.e. with a limited duration over time), may lead to malfunctions of the device or even to the destruction of the gate region if the gate signal path is not designed correctly in terms of parasitic components (resistance and inductance).

For the purposes of mitigating the oscillation phenomena on the gate terminal of GaN power devices, different topologies of the distribution grid of the gate signal have been analyzed in the literature, with results in terms of time stability of the gate signal waveforms during switching of the devices which may be unsatisfactory depending on the application in question.

### Summary

It is therefore an aim of the present invention to overcome or at least mitigate the disadvantages and limitations of the state of the art.

According to the present invention, there is provided a HEMT device with reduced gate oscillation and manufacturing process thereof, as defined in the attached claims.

### Brief Description of the Figures

For a better understanding of the present invention, preferred embodiments are provided, by way of non-limiting example, with reference to the attached drawings, wherein:
- Figure 1 is a top-plan view of a power device in accordance with an embodiment of the present invention;
- Figure 2 is a perspective view of an internal portion of the power device of Figure 1;
- Figure 3 is a cross-section of an internal portion of the power device of Figure 1;
- Figure 4 is an electric diagram relating to the power device of Figure 1; and
- Figures 5-7 are top-plan views of the power device of Figure 1 in subsequent steps of a manufacturing process thereof.

### Description of Embodiments

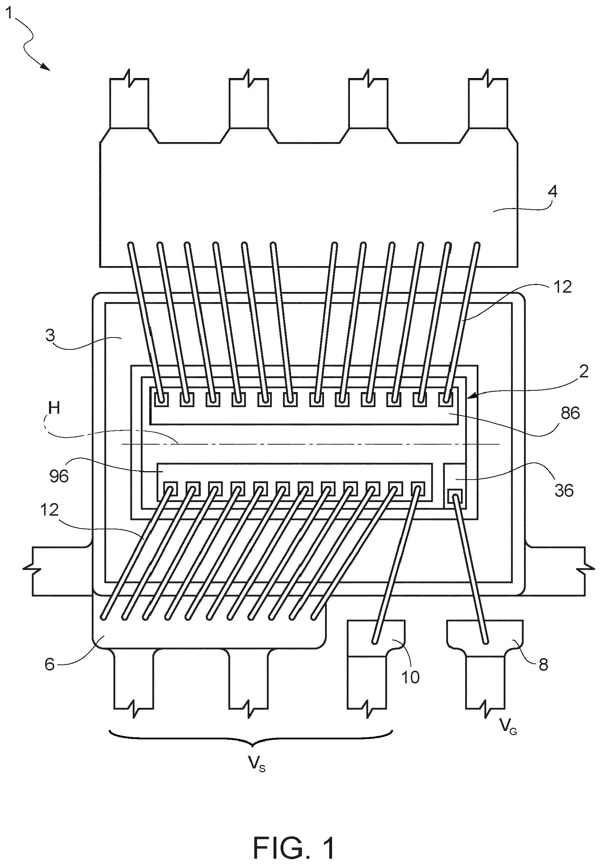

With reference to Figure 1, a power device in accordance with an embodiment of the present invention is indicated, as a whole, with the numeral 1 and comprises a die, or chip, 2, and a frame 3 having the die 2 accommodated therein. The power device 1 further comprises: a first terminal 4, a second terminal 6 and a third terminal 8, which respectively define in use the external drain terminal, the external source terminal and the external gate terminal (also said "control terminal") of the power device 1; a fourth terminal 10, also called "sensing terminal" or "Kelvin terminal", which defines a reference for the control signal applied to the external gate terminal 8, and therefore for switching the power device 1, and is typically at the same potential as the external source terminal 6.

The terminals 4, 6, 8, 10 of the power device 1 may be mechanically coupled to the frame 3 and are electrically connected to relative pads of the die 2 (see below) by bonding wires 12.

The power device 1 may also comprise an insulating body of a resin or other polymeric material (not shown in the attached Figures) from which the terminals 4, 6, 8, 10 may protrude through a plurality of protrusions (at least one) for respective terminal which remain exposed to be accessible from the outside.

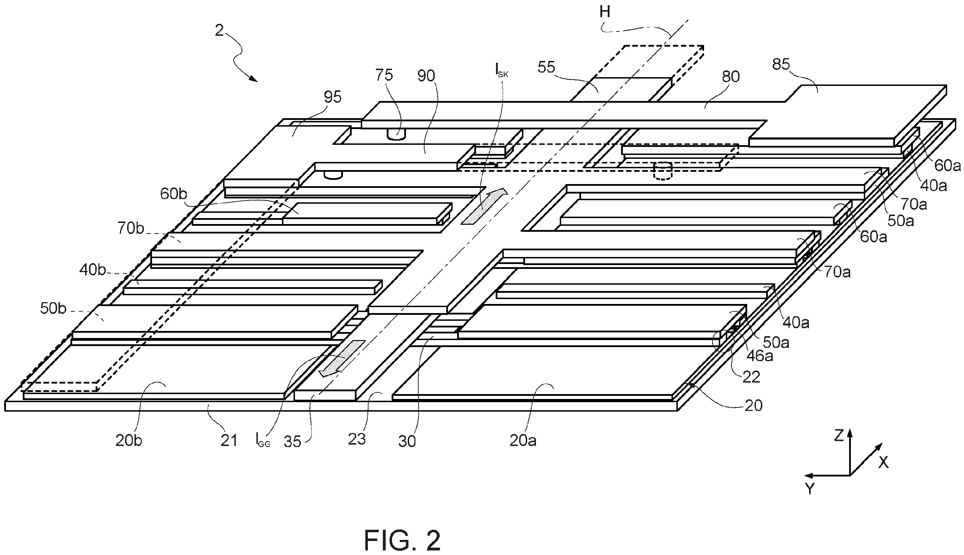

Figure 2 illustrates an internal portion of the die 2 in a triaxial reference system of axes orthogonal to each other X, Y, Z. The die 2 comprises an active region 20, which extends in a planar manner in the directions of the X and Y axes above a substrate 21 and is divided, along the Y axis, into a first active area 20a and a second active area 20b identical to each other.

The first and the second active areas 20a, 20b extend in an identical manner to each other inside the die 2, i.e. they have the same dimensions along the X axis and the Y axis, and are arranged symmetrically opposite with respect to an axis of symmetry H parallel to the X axis. The first and the second active areas 20a, 20b are also separated by a separation region 23 of the same semiconductor material as the substrate 21, which is arranged centrally to the die 2 and extends parallel to the axis of symmetry H. The first and the second active areas 20a, 20b are therefore at a distance from each other and the separation region 23 is interposed therebetween. The first and the second active areas 20a, 20b define two identical and separate power modules of the power device 1.

The substrate 21 may comprise, for example, a silicon (Si) layer or a silicon carbide (SiC) layer and a gallium nitride (GaN) buffer layer, not shown separately in the accompanying Figures.

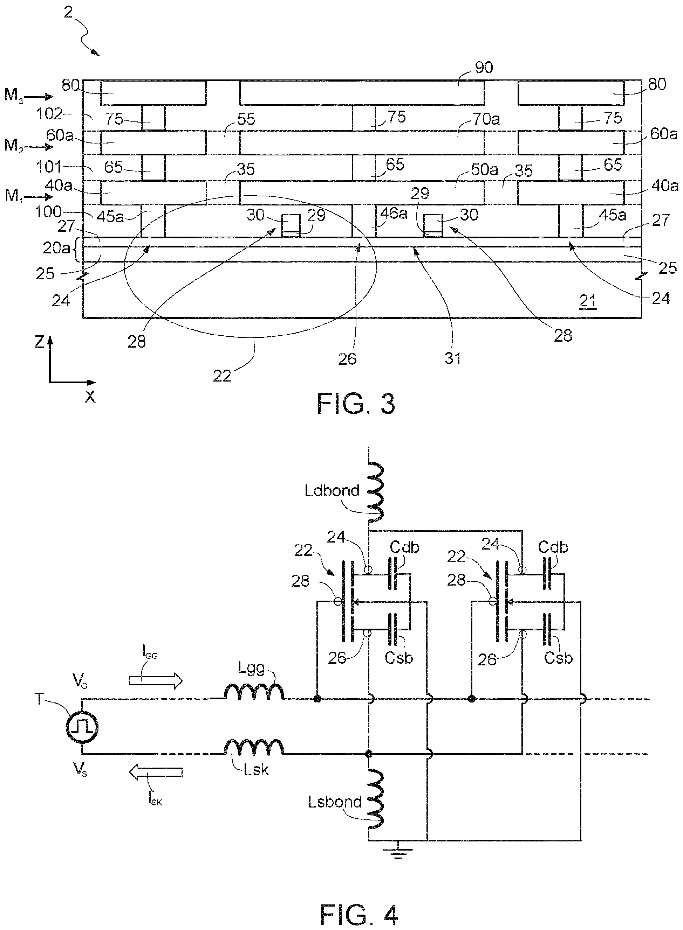

The first and the second active areas 20a, 20b comprise a plurality of active elements 22, identical to each other and distributed in a specular manner. The active elements 22, as also shown in Figure 3, are equal to each other, are arranged side by side in a periodic manner along the X axis and extend parallel to the Y axis.

The active elements 22 may be transistors of the HEMT type. In this case, the first and the second active areas 20a, 20b each comprise a channel layer 25 and a barrier layer 27. The channel layers 25 of the first and the second active areas 20a, 20b extend on the substrate 21 and are formed by a first semiconductor material, for example, of gallium nitride (GaN). The barrier layers 27 are superimposed, in contact, each on a respective channel layer 25 and are formed by a second semiconductor material, different from the first, for example, of aluminum gallium nitride (AlGaN). The channel layers 25 and the barrier layers 27 may have, for example, N-type conductivities and define a heterostructure. Interfaces between the channel layers 25 and the barrier layers 27 define heterojunctions 31.

The active elements 22 are provided with respective drain terminals 24, source terminals 26 and gate terminals 28 and comprise respective portions of the channel layers 25 and of the barrier layers 27 and respective gate regions 29.

Each gate region 29 extends above and in contact with the respective barrier layer 27 and acts as a control region of each active element 22, in particular as a channel modulation region; the gate region 29 is formed by a conductive material, typically a third doped semiconductor material, such as for example P-type conductivity gallium nitride (pGaN). As known, the gate region 29 operates, on the basis of the voltage applied thereon, so as to modulate the thickness of the conductive channel which forms at the interface between the channel layer 25 and the barrier layer 27; the gate region 29, moreover, ensures the operation in the so-called "normally-off" mode to an active element 22 of the HEMT type.

The power device 1 of the present embodiment may therefore be a HEMT power device of GaN-type which exploits, as is typical in the sector, a plurality of elementary cells (namely, the active elements 22) electrically connected in parallel in order to increase the conductive properties thereof (in terms of maximum current that can be supplied) to the external drain and source terminals 4, 6. The die 2 of the power device 1 may have maximum dimensions, for example, equal to 7 mm along the X axis and 2 ÷ 3 mm along the Y axis, and each power module defined by the first and the second active areas 20a, 20b may contain, for example, 50 ÷ 200 active elements 22. The first and the second active areas 20a, 20b may extend along the Y axis with typical lengths equal to 0.5 ÷ 1.5 mm and the relative separation region 23 may extend along the Y axis for example for 20 ÷ 60 um.

The drain, source and gate terminals 24, 26, 28 of each active element 22 have substantially the shape of a strip and extend parallel to the Y axis according to the topology shown in Figure 2.

In detail, the gate terminal 28 of each active element 22, for example a conductive multilayer of TiN/AlCu/TiN, extends above and in direct electrical contact with the respective gate region 29 and is formed through a common metallization step for all the active elements 22 of both the first and the second active areas 20a, 20b. In particular, the gate terminals 28 are defined by respective gate electrodes or "fingers" 30 which extend without interruptions along the Y axis throughout all the active region 20, including the separation region 23, and connect gate regions 29 symmetrically opposite with respect to the axis of symmetry H.

In other words, the gate electrodes 30 extend throughout the entire length of the die 2 parallel to the Y axis and also run above the separation region 23. The gate electrodes 30 are obtained following deposition and lithographic definition steps, using techniques that are typical of the sector ("etching").

The drain and source terminals 24, 26 of each active element 22 are defined, for the first active area 20a, by respective drain electrodes 40a and by respective source electrodes 50a, while, for the second active area 20b, by respective drain electrodes 40b and by respective source electrodes 50b. The drain electrodes 40a, 40b have equal extension along the Y axis and the source electrodes 50a, 50b have equal extension along the Y axis. The position of the drain electrodes 40a and of the source electrodes 50a is symmetrical with respect to the H axis to the position of the drain electrodes 40b and the source electrodes 50b, respectively. Furthermore, the drain electrodes 40a, 40b are separated from each other at the separation region 23, as well as the source electrodes 50a, 50b. The drain electrodes 40a, 40b and the source electrodes 50a, 50b are formed starting from a same first level of metallization M₁, over and through a first intermediate insulating layer 100, of dielectric material, which covers the active region 20. The drain electrodes 40a, 40b and the source electrodes 50a, 50b are hereinafter referred to as first-level drain electrodes and first-level source electrodes.

Considering the first active area 20a (but the same considerations also apply to the second active area 20b) and referring to Figures 2 and 3, the first-level drain electrodes 40a and the first-level source electrodes 50a extend above the first active area 20a alternating to each other, forming a repetitive pattern, along the X axis. The first-level drain electrodes 40a and the first-level source electrodes 50a are in direct contact with the heterostructure of the first active area 20a, defining the respective drain and source terminals 24, 26 of the relative active elements 22. More precisely, the first-level drain electrodes 40a and the first-level source electrodes 50a have respective contact portions 45a, 46a (contact portions 45b, 46b refer, in an identical manner, to the second active area 20b) which extend through the first intermediate insulating layer 100 and run along the Y axis, forming the drain and source terminals 24, 26.

In detail, a first-level source electrode 50a is shared by two adjacent active elements 22, which therefore share the same source terminal 26. The first-level source electrodes 50a extend above pairs of consecutive gate electrodes 30 and contact the first active area 20a in intermediate positions between these consecutive gate electrodes 30.

The alternate pattern of the first-level drain electrodes 40a and the first-level source electrodes 50a is such that, observing in section two adjacent active elements 22 (Figure 3), two first-level drain electrodes 40a placed laterally and symmetrically with respect to the first-level source electrode 50a correspond to a central first-level source electrode 50a. Furthermore, the first-level source electrodes 50a extend above pairs of respective gate electrodes 30 so that a projection of these gate electrodes 30, along the Z axis, is completely contained in these source electrodes 50a; an arrangement of this type typically ensures electrical shielding functions to the corresponding gate regions 29.

The first level of metallization M₁ also comprises a main electrode or gate "bus" 35 which extends in a transversal manner to the gate electrodes 30, i.e. along the X axis. In detail, the gate bus 35 extends above the gate electrodes 30 and centrally to the die 2: the gate bus 35 is in fact interposed between the first and the second active areas 20a, 20b at the separation region 23, whereon it is superimposed; the H axis is therefore an axis of symmetry of the gate bus 35. In other words, the gate bus 35 extends above a region of the die 2 wherein the active elements 22 are absent.

The gate bus 35 is electrically connected to the gate electrodes 30 by vias of conductive material which extend along the Z axis (not shown in the attached Figures) and distributes to the gate electrodes 30, and therefore to the active elements 22, the external control signal. The central arrangement of the gate bus 35 allows a symmetrical and balanced distribution of this control signal, in terms of parasitic components of the electrical paths, to both power modules defined by the first and the second active areas 20a, 20b: the relative gate regions 29 therefore switch almost simultaneously and in a balanced manner for all the active elements 22 in parallel; the driving of the two power modules is therefore coherent.

The gate bus 35 may have a length close to the length along the X axis of the die 2 and a width (along the Y axis) normally comprised between 10 and 50 um.

The first level of metallization M₁ is separated from the active region 20, along the Z axis, by the first intermediate insulating layer 100. The necessary electrical connections between the first-level drain and source electrodes 40a, 40b, 50a, 50b and the drain and source terminals 24, 26 of the active elements 22 are ensured by the contact portions 45a, 46a, 45b, 46b through the first intermediate insulating layer 100.

The first-level drain and source electrodes 40a, 40b, 50a, 50b and the gate bus 35 are all obtained starting from the same deposition and definition processes of first level of metallization M₁ and may be formed for example with a multilayer of TiN/AlCu/TiN.

The power device 20 further comprises a second insulating layer 101 on the first intermediate insulating layer 100 and a second level of metallization M₂ of the power device 20 on the second intermediate insulating layer 101. The second level of metallization M₂ overlies the first level of metallization M₁ and comprises: a source main electrode ("bus") 55; second-level drain electrodes 60a and second-level source electrodes 70a on the first active area 20a; second-level drain electrodes 60b and second-level source electrodes 70b on the second active area 20b. The source bus 55 extends along the X axis while the second-level drain electrodes 60a, 60b and the second-level source electrodes 70a, 70b extend in a transversal manner to the source bus 55, i.e. along the Y axis. The second-level source electrodes 70a, 70b are in direct electrical and structural connection with the source bus 55. More precisely, the second-level source electrodes 70a, 70b extend monolithic from the source bus 55 in opposite directions with respect to the H axis towards the respective first and second active areas 20a, 20b and represent "fingers" of the source bus 55.

In detail, the source bus 55 extends along the H axis, which is also an axis of symmetry of the source bus 55, and completely overlies the gate bus 35, shielding it electrically: the shielding function given by the structure of the source connections of second level of metallization M₂ is explained in more detail below.

The source bus 55 may have a length close to the size of the die 2 along the X axis and a width at least equal to the width of the gate bus 35 along the Y axis and with a value normally comprised between 10 and 50 um.

Considering the first active area 20a (but the same considerations also apply to the second active area 20b) and referring to Figures 2 and 3, the second-level drain electrodes 60a and the second-level source electrodes 70a are arranged alternating to each other, forming a repetitive pattern, along the X axis. In particular, the second-level drain electrodes 60a are "interdigitated" between two consecutive second-level source electrodes 70a. Furthermore, the second-level drain electrodes 60a and the second-level source electrodes 70a at least partially overlie respective first-level drain electrodes 40a and first-level source electrodes 50a. The second-level drain electrodes 60a and the second-level source electrodes 70a are in electrical connection with the respective first-level drain electrodes 40a and first-level source electrodes 50a by second-level vias 65, of conductive material, that extend along the Z axis.

The structure of the source connections of second level of metallization M₂ is therefore such that a pair of second-level source electrodes 70a, 70b extends, starting from the source bus 55, in a symmetrical opposite manner with respect to the H axis towards, respectively, the first and the second active areas 20a, 20b and overlying, respectively, a pair of first-level source electrodes 50a, 50b.

The second-level drain electrodes 60a, 60b are instead separated from each other at the separation region 23.

The second level of metallization M₂ is separated from the first level of metallization M₁, along the Z axis, by the second intermediate insulating layer 101. The necessary electrical connections between the second-level drain and source electrodes 60a, 60b, 70a, 70b and the first-level drain and source electrodes 40a, 40b, 50a, 50b are ensured by the second-level vias 65 through the second intermediate insulating layer 101.

The second-level drain and source electrodes 60a, 60b, 70a, 70b and the source bus 55 are all obtained starting from the same deposition and definition processes of second level of metallization M₂ and may be formed for example with a multilayer of TiN/AlCu/TiN.

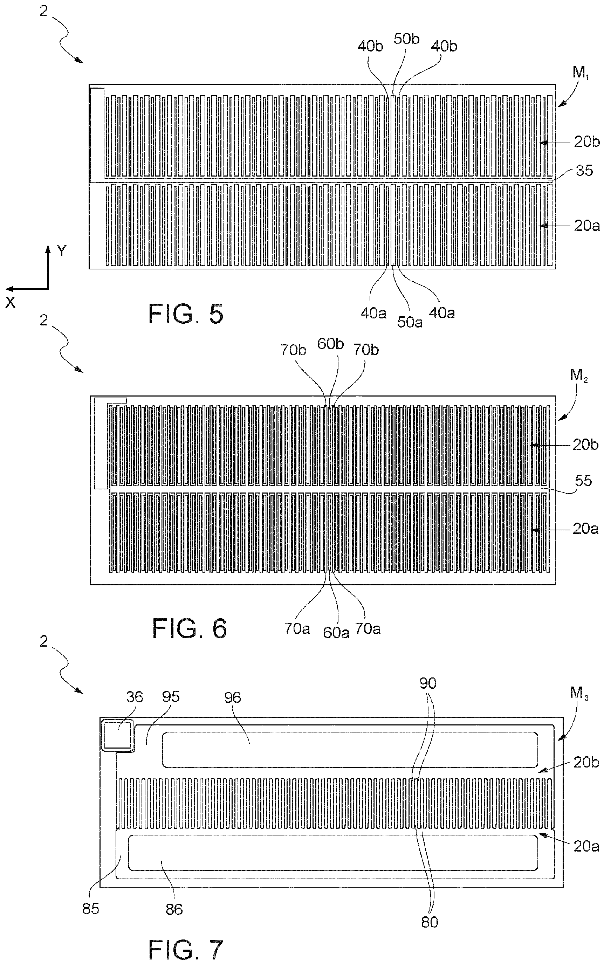

The power device 20 comprises a third intermediate insulating layer 102 on the second intermediate insulating layer 101 and a third level of metallization M₃ on the third intermediate insulating layer 102. The third level of metallization M₃ overlies the second level of metallization M₂ and comprises: a drain metallization region 85 and a source metallization region 95, identical and symmetrical with respect to the H axis, third-level drain electrodes 80 which extend from the drain metallization region 85 and third-level source electrodes 90 which extend from the source metallization region 95. The drain and source regions 85, 95 respectively overlie the first and the second active areas 20a, 20b. The third-level drain and source electrodes 80, 90 extend along the Y axis monolithic from the respective drain and source regions 85, 95. The third-level drain electrodes 80 and the source electrodes 90 extend above the second level of metallization M₂, starting from the drain regions 85 and the source regions 95, respectively, in such a way that, along the X axis, third-level drain electrodes 80 alternate with third-level source electrodes 90, i.e. they are "interdigitated" with each other (see also Figure 7).

As a result, the third-level drain and source electrodes 80, 90 form "fingers" of the respective drain and source regions 85, 95. Furthermore, each third-level drain electrode 80 overlies (at least partially) and is electrically connected to a pair of second-level drain electrodes 60a, 60b symmetrically opposite with respect to the H axis. Similarly, each third-level source electrode 90 overlies (at least partially) and is electrically connected to a pair of second-level source electrodes 70a, 70b symmetrically opposite with respect to the H axis. These electrical connections between the third level of metallization M₃ and the second level of metallization M₂ are formed by third-level vias 75, of conductive material, which extend along the Z axis through the third intermediate insulating layer 102.

The third-level drain and source electrodes 80, 90 and the drain and source regions 85, 95 are all obtained starting from the same deposition and definition processes of third level of metallization M₃ and may be formed for example with a multilayer of TiN/AlCu/TiN.

The third level of metallization M₃ may also be provided, in this type of power devices, with pads which allow the electrical connection to different external levels of electric potential as previously described.

In particular, referring to Figures 1, 2 and 7, a drain pad 86 extends above the drain metallization region 85, wherewith it is in direct electrical connection, while a source pad 96 extends above the source metallization region 95, wherewith it is in direct electrical connection. Furthermore, the third level of metallization M₃ comprises a gate pad 36, typically placed at a corner of the die 2 and arranged side by side to the source metallization region 95, wherefrom it is electrically insulated. The gate pad 36 is electrically connected to the gate bus 35 by at least one via of conductive material which extends along the Z axis (not shown in the attached Figures) through the intermediate insulating layers 100, 101, 102 up to the first level of metallization M₁; the gate pad 36 then provides the external control signal to the gate bus 35 to be distributed to the active elements 22.

The drain, source and gate pads 86, 96, 36 are accessible for coupling with the bonding wires 12 in the definition of the "lead frame" of the power device 1. In particular, the drain pad 86 is connected to the external drain terminal 4, the source pad 96 is connected to the external source terminal 6 and the gate pad 36 is connected to the external gate terminal 8. The sensing terminal 10, which is typically at the same potential as the external source terminal 6, is therefore connected to the source pad 96.

The first, the second and the third levels of metallization M₁, M₂, M₃ therefore ensure, in the embodiment presented, that the drain, source and gate electrical paths reach the respective correct electric potentials relating to the voltages externally applied, allowing the flow of the currents thereof through the structure of the power device 1.

It should be noted that in Figure 2 portions of the first, the second and the third levels of metallization M₁, M₂, M₃ and of the gate electrodes 30 have been intentionally omitted for clarity of understanding.

The identical dimensions of the first and the second active areas 20a, 20b allow a balance in terms of conductive paths for the current flowing between the external drain and source terminals 4, 6; in fact, these terminals, as well as the respective drain and source pads 86, 96 of the present topology, are shared by both the first and the second active areas 20a, 20b. Concurrently, the arrangement of the gate bus 35 above the separation region 23 allows the insulation of the distribution grid of the control signal from the potential difference, in use, between the drain and source electrodes of the power device 1, which may assume values, for example, two orders of magnitude greater than the voltage levels of the control signal.

The first and the second levels of metallization M₁, M₂ of the power device 1 are configured to minimize the inductive parasitic components of the electrical path of the control signal; any unwanted oscillations of the control signal during the switching steps are consequently reduced, decreasing the probability of damage to the gate regions 29.

In detail, phenomena of cancellation of control signal current flows flowing in opposite directions contribute to minimizing the inductive parasitic components. This cancellation is made possible by the topology described above, and, in more detail, by the gate loop created by the arrangement of the first and the second levels of metallization M₁, M₂.

With reference to Figures 2 and 4, when a control signal T is applied between the external gate terminal 8 and the sensing terminal 10, a forward current I_{GG} of the control signal flows in the gate bus 35 in the negative direction of the X direction and a corresponding return current I_{SK} flows in the source bus 55 in the positive direction of the X direction, i.e. in the direction opposite to that of the forward current I_{GG}. The return current I_{SK} in fact shares the same conductive path as the source metallizations since the sensing terminal 10 is connected, as described, to the source pad 96; the source bus 55 therefore represents a return path of the control signal loop, the sensing terminal 10 being the reference terminal of the voltage applied to the external gate terminal 8.

The previously described superimposition of the source bus 55 on the gate bus 35 allows, ultimately, the inductive effects of the forward current I_{GG} and of the return current I_{SK} to be cancelled since they flow in opposite directions; the source bus 55 therefore has the function of electrical shielding of the gate bus 35. Even more in detail, the source bus 55 is interposed between the gate bus 35 and the drain structures of the third level of metallization M₃ and has the effect of minimizing the capacitance existing between gate terminals 28 and drain terminals 24 and thus of decoupling the control signal from the electrical potential of the drain. Furthermore, since the source bus 55 and the gate bus 35 run on a central region of the power device 1 along the axis of symmetry H, the synchronization of the switchings of the active elements 22 is ensured.

Figure 4 shows in a circuit diagram the mechanism for canceling the current flows of the control signal. In detail, the circuit diagram has two active elements 22 of HEMT-type described above parallel connected to each other. Through the external gate terminal 8 and the sensing terminal 10, the control signal (graphically represented by a square wave generator T) is applied between the gate terminals 28 and the source terminals 26 of the active elements 22, giving rise to the forward and return currents I_{GG}, I_{SK}. Inductances L_{GG} and L_{SK} represent the parasitic components of the power device 1 in the gate loop, respectively in the forward and return path; inductances L_{DBOND} and Ls_{BOND} instead represent the inductive losses generated by the bonding wires 12 (called "bonding inductances"). Capacitances C_{DB} and C_{SB} are present in this type of devices active respectively between the drain terminals 24 and the substrate 21 and between the source terminals 26 and the substrate 21.

As a result, the minimization of the inductive parasitic components L_{GG} and L_{SK} due to the cancellation of the current flows significantly reduces the possibility of forming "LC"-type resonant circuits with the substrate capacitances C_{DB} and C_{SB}; these resonant circuits are in fact one of the causes of uncontrolled oscillations and peaks at the gate terminals 28 during the switching phases.

The described power device 1 may be obtained by the following simplified manufacturing process, according to which the first, the second and the third levels of metallization M₁, M₂, M₃ of the die 2 are deposited and defined as shown in Figures 5-7.

In particular, the die 2 is provided being part of a semiconductor wafer not illustrated, and already provided with the substrate 21, the active region 20 and the gate electrodes 30; the substrate 21, the active region 20 and the gate electrodes 30 are protected by the first intermediate insulating layer 100, of dielectric material. A first deposition of metal layer (Figure 5) and subsequent lithographic definition, using etching procedures typical of the sector, give rise to the first level of metallization M₁. In detail, the first-level drain and source electrodes 40a, 40b, 50a, 50b and the gate bus 35 are formed. As may be observed in Figure 5, the gate bus 35 is "L"-shaped outside the active region 20 so that it may be connected through relative vias of conductive material (not shown in the attached Figures) to the gate pad 36 of the subsequent third level of metallization M₃.

The contact portions 45a, 46a, 45b, 46b are also defined, at relative openings already formed in the first intermediate insulating layer 100, in order to ensure the necessary electrical connections (reference be made to Figure 3) between the first level of metallization M₁ and the underlying gate electrodes 30 and active region 20.

The second intermediate insulating layer 101 is then formed, which covers the first level of metallization M₁. Subsequently, a second deposition of metal layer (Figure 6) and subsequent lithographic definition, with techniques which may be identical to the first deposition, give rise to the second level of metallization M₂. In detail, the second-level drain and source electrodes 60a, 60b, 70a, 70b and the source bus 55 are formed. As may be observed in Figure 6, the source bus 55 is also ("L") shaped so as to shield the underlying gate bus 35 throughout its extension.

The second-level vias 65 are also defined, at relative openings formed in the second intermediate insulating layer 101, in order to ensure the necessary electrical connections (reference be made to Figure 3) between the second level of metallization M₂ and the first level of metallization M₁.

The third intermediate insulating layer 102 is then formed, which covers the second level of metallization M₂. Subsequently, a third deposition of metal layer (Figure 7) and subsequent lithographic definition, with techniques which may be identical to the first and the second depositions, give rise to the third level of metallization M₃. In detail, the third-level drain and source electrodes 80, 90 and the drain and source regions 85, 95 are formed; subsequently the drain, source and gate pads 86, 96, 36 are also defined.

The third-level vias 75 are also defined, at relative openings formed in the third intermediate insulating layer 102, in order to ensure the necessary electrical connections (reference be made to Figure 3) between the third level of metallization M₃ and the second level of metallization M₂.

Finally, in a manner not shown in the attached Figures, the final steps of the present manufacturing process follow, comprising depositing any dielectric passivation layers above the third level of metallization M₃, dicing the wafer to obtain the die 2, positioning the die 2 inside the frame 3 and coupling the pads of the die 2 to the relative external terminals by the wire bondings 12, and therefore the steps of co-molding the insulating body, thus obtaining the power device 1 of Figure 1.

Finally, it is clear that modifications and variations may be made to what has been described and illustrated herein without thereby departing from the scope of the present invention, as defined in the attached claims.

For example, the active elements 22 may be of a type different from the GaN HEMT type, for example GaAs (gallium arsenide) HEMT, capable of operating at high voltages (up to hundreds of Volts) and with currents that have rapid switching time trends.

The active region 20 may for example comprise further layers inside the relative heterostructures defined by the first and the second active areas 20a, 20b, in addition to the channel layer 25, the barrier layer 27 and the gate region 29 described above.

The die 2 may for example be provided with further levels of metallization, and relative intermediate insulating layers, in addition to the first, the second and the third levels of metallization M₁, M₂, M₃ described above.

## Claims

1. A heterojunction power device (1) comprising:
- a substrate (21) containing semiconductor material;
- a first active area (20a) and a second active area (20b), arranged on the substrate (21) symmetrically opposite with respect to an axis of symmetry (H) and accommodating respective heterostructures (25, 27, 29);
- a separation region (23), extending along the axis of symmetry (H) between the first active area (20a) and the second active area (20b);
- a gate conductive bus (35) configured to distribute a first electric potential (V_{G}) of the power device (1) in parallel to the first and the second active areas (20a, 20b);
- a source conductive bus (55) configured to distribute a second electric potential (V_{S}) of the power device (1), different from the first electric potential (V_{G}), in parallel to the first and the second active areas (20a, 20b);
wherein the gate conductive bus (35) and the source conductive bus (55) extend along the axis of symmetry (H) above the separation region (23), the source conductive bus (55) overlying the gate conductive bus (35).

2. The power device according to claim 1, wherein the first electric potential (V_{G}) is a control signal of the power device (1).

3. The power device according to any of the preceding claims, wherein the second electric potential (V_{S}) is a source electric potential of the power device (1).

4. The power device according to any of the preceding claims, comprising a first level of metallization (M₁), wherein the gate conductive bus (35) is a portion of the first level of metallization (M₁); the first level of metallization (M₁) further comprising:
- first-level drain electrodes (40a) and first-level source electrodes (50a) associated with the first active area (20a), extending transversely to the gate conductive bus (35) and superimposed on the first active area (20a);
- first-level drain electrodes (40b) and first-level source electrodes (50b) associated with the second active area (20b), extending transversely to the gate conductive bus (35), superimposed on the second active area (20b) and separated, at the separation region (23), from the first-level drain electrodes (40a) and from the first-level source electrodes (50a) associated with the first active area (20a).

5. The power device according to the preceding claim, wherein the first-level drain electrodes (40a) and the first-level source electrodes (50a) associated with the first active area (20a) are arranged in a symmetrical manner, with respect to the axis of symmetry (H), to respective first-level drain electrodes (40b) and first-level source electrodes (50b) associated with the second active area (20b);
and wherein in the first active area (20a) and in the second active area (20b) the first-level drain electrodes (40a, 40b) are arranged alternating, along the axis of symmetry (H), with the first-level source electrodes (50a, 50b).

6. The power device according to the preceding claim, comprising a second level of metallization (M₂) superimposed on the first level of metallization (M₁), wherein the source conductive bus (55) is a portion of the second level of metallization (M₂); the second level of metallization (M₂) further comprising:
- second-level drain electrodes (60a) and second-level source electrodes (70a) associated with the first active area (20a), extending transversely to the source conductive bus (55) and superimposed on the first active area (20a);
- second-level drain electrodes (60b) and second-level source electrodes (70b) associated with the second active area (20b), extending transversely to the source conductive bus (55) and superimposed on the second active area (20b);
the second-level source electrodes (70a, 70b) extending from the source conductive bus (55) in opposite directions with respect to the axis of symmetry (H);
the second-level drain electrodes (60a) associated with the first active area (20a) being separated, at the separation region (23), from the second-level drain electrodes (60b) associated with the second active area (20b).

7. The power device according to the preceding claim, wherein the second-level drain electrodes (60a) and the second-level source electrodes (70a) associated with the first active area (20a) are arranged, with respect to the axis of symmetry (H), in a manner symmetrical, to the second-level drain electrodes (60b) and to the second-level source electrodes (70b) associated with the second active area (20b); and
the second-level drain electrodes (60a, 60b) being arranged alternating, along the axis of symmetry (H), with the second-level source electrodes (70a, 70b).

8. The power device according to the preceding claim, comprising a third level of metallization (M₃), superimposed on the second level of metallization (M₂), provided with:
- a drain metallization region (85), superimposed on the first active area (20a);
- a source metallization region (95), superimposed on the second active area (20b);
- third-level drain electrodes (80) and third-level source electrodes (90), extending transversely to the axis of symmetry (H) starting from the drain metallization region (85) and from the source metallization region (95), respectively;
the third-level drain electrodes (80) being arranged alternating, along the axis of symmetry (H), with the third-level source electrodes (90).

9. The power device according to the preceding claim, comprising second-level conductive vias (65) between the first level of metallization (M₁) and the second level of metallization (M₂) and third-level conductive vias (75) between the second level of metallization (M₂) and the third level of metallization (M₃).

10. The power device according to any of the preceding claims, wherein the first and the second active areas (20a, 20b) each comprise:
- a respective channel layer (25) and a respective barrier layer (27) defining respective heterojunctions (31);
- a plurality of respective active elements (22), extending transversely to the axis of symmetry (H) and arranged periodically along the axis of symmetry (H);
wherein the active elements (22) comprise respective portions of the channel layers (25) and of the barrier layers (27) and respective gate regions (29) superimposed, in contact, on the barrier layer (27) of the respective active area (20a, 20b); the active elements (22) each further comprising a drain terminal (24), a source terminal (26) and a gate terminal (28);
the gate terminals (28) comprising gate electrodes (30), superimposed, in contact, on respective gate regions (29) and extending transversely to the axis of symmetry (H).

11. The power device according to claim 10, when dependent on claim 8, wherein:
the third-level drain electrodes (80), the second-level drain electrodes (60a, 60b), the first-level drain electrodes (40a, 40b) and the drain terminals (24) of the active elements (22) are superimposed on each other and all electrically connected to each other in a direct manner;
the third-level source electrodes (90), the second-level source electrodes (70a, 70b), the source conductive bus (55), the first-level source electrodes (50a, 50b) and the source terminals (26) of the active elements (22) are superimposed on each other and all electrically connected to each other in a direct manner;
the first-level drain electrodes (40a, 40b) and the first-level source electrodes (50a, 50b) have respective contact portions (45a, 46a, 45b, 46b) which extend transverse to the axis of symmetry (H) and form the drain terminals (24) and the source terminals (26).

12. The power device according to claim 10 or 11, wherein the gate conductive bus (35), the gate electrodes (30) and the gate terminals (28) are all electrically connected to each other in a direct manner.

13. The power device according to any of claims 10 to 12, wherein the active elements (22) are HEMT-type transistors, electrically connected to each other in parallel and formed in gallium nitride technology.

14. A process for manufacturing a heterojunction power device (1) comprising:
on a substrate (21) containing semiconductor material, forming a first active area (20a) and a second active area (20b) symmetrically opposite with respect to an axis of symmetry (H), accommodating respective heterostructures (25, 27, 29) and separated by a separation region (23), extending along the axis of symmetry (H);
forming, on the separation region (23), a gate conductive bus (35) configured to distribute a first electric potential of the power device (1) in parallel to the first and the second active areas (20a, 20b);
forming, on the separation region (23), a source conductive bus (55) configured to distribute a second electric potential (V_{S}) of the power device (1), different from the first electric potential (V_{G}), in parallel to the first and the second active areas (20a, 20b);
wherein the gate conductive bus (35) and the source conductive bus (55) extend along the axis of symmetry (H), the source conductive bus (55) overlying the gate conductive bus (35) .

15. The manufacturing process according to the preceding claim, comprising:
forming a first level of metallization (M₁);
from the first level of metallization (M₁) forming:
- the gate conductive bus (35);
- first-level drain and source electrodes (40a, 40b, 50a, 50b), extending transversely to the gate conductive bus (35), configured to provide, respectively, drain electric potentials and source electric potentials of the power device (1) to the first active area (20a) and to the second active area (20b);
forming a second level of metallization (M₂) above first level of metallization (M₁); and
from the second level of metallization (M₂) forming:
- the source conductive bus (55);
- second-level source electrodes (70a, 70b), extending from the source conductive bus (55) in opposite directions with respect to the axis of symmetry (H) and transversely to the source conductive bus (55), electrically connected to the first-level source electrodes (50a, 50b);
- second-level drain electrodes (60a, 60b), extending transversely to the source conductive bus (55) and electrically connected to the first-level drain electrodes (40a, 40b).
